# EUROPÄISCHE PATENTANMELDUNG

(11) **EP 4 435 458 A1**
(43) Veröffentlichungstag der Anmeldung: **25.09.2024**
(21) Anmeldenummer: 23202399.4
(22) Anmeldetag: 09.10.2023
(51) Int. Cl.: G01R 33/385

(54) **STIMULATIONSOPTIMIERTE GRADIENTENSPULE**

(71) Anmelder: Siemens Healthineers AG, 91301 Forchheim (DE)
(72) Erfinder: Bauer, Simon, 91330 Eggolsheim (DE); Fath, Sascha, 91052 Erlangen (DE); Krug, Andreas, 90762 Fürth (DE)
(74) Vertreter: Siemens Healthineers Patent Attorneys

(57) **Zusammenfassung**

Die Gradientenspulenanordnung eines MRT-Systems definiert eine erste und zumindest eine zweite Achse in unterschiedlichen Raumrichtungen. In jeder Raumrichtung ist mindestens eine Gradientenspule angeordnet, die ein magnetisches Gradientenfeld entlang der jeweiligen Achse erzeugt. Die magnetischen Gradientenfelder weisen jeweils einen Maximalfeldbereich auf, der einer Region entspricht, in der die Feldstärke einen vorbestimmten Prozentsatz der maximalen Stärke erreicht. Die Gradientenspule der ersten Achse ist so konfiguriert, dass die Überschneidung ihres Maximalfeldbereichs mit dem der zumindest einen zweiten Achse kleiner als ein Grenzwert ist.

## Beschreibung

Die vorliegende Erfindung betrifft das Gebiet der medizinischen Bildgebung, insbesondere die Konstruktion von Gradientenspulenanordnungen für Magnetresonanztomographie-Systeme.

Die Magnetresonanztomographie (MRT) ist ein nicht-invasives bildgebendes Verfahren, das weithin für die Diagnose einer Vielzahl von Krankheiten und Zuständen verwendet wird. MRT-Geräte setzen Patienten zeitabhängigen magnetischen Gradientenfeldern aus, die jedoch innerhalb des Körpers des Patienten elektrische Felder erzeugen können. Diese elektrischen Felder können eine periphere Nervenstimulation (PNS) verursachen, beispielsweise in starken Feldsituationen potenziell auch das Herz stimulieren, was unerwünscht ist. Dies macht eine Begrenzung der Amplituden und Anstiegszeiten der Gradientenfelder notwendig, was jedoch die Gesamtleistung des Gradientensystems einschränkt.

Es wurde festgestellt, dass die Stimulationsschwellen, d.h., die Amplituden/Anstiegszeiten, bei denen eine Stimulation auftreten kann, weitgehend von der Gestaltung der Gradientenspulen abhängen, die die Gradientenfelder erzeugen.

Bestehende Lösungen zur Optimierung der Stimulationsleistung von Gradientenspulen optimieren die Stimulationswirkung einzelner Gradientenspulen. Um die Schwellenwerte zu erhöhen, erhöhen diese Lösungen entweder die Induktivität der Spule oder beeinträchtigen deren Linearität. Diese Methoden führen jedoch oft zu Leistungsverlusten, die die Effektivität und Genauigkeit des MRT-Scans beeinträchtigen können.

Daher besteht ein Bedarf an verbesserten Lösungen für die Gestaltung und Optimierung von Gradientenspulen in MRT-Geräten, um das Problem der peripheren Nervenstimulation zu mindern.

Diese Aufgabe wird durch den Gegenstand der unabhängigen Diese Aufgabe wird mit den Merkmalen der unabhängigen Ansprüche gelöst. In den abhängigen Ansprüchen sind weitere vorteilhafte Ausführungsbeispiele beschrieben.

Im Folgenden werden Techniken in Bezug auf die beanspruchten Gradientenspulenanordnungen und die beanspruchten medizinischen Bildgebungssysteme (z.B. MRT-Systeme) beschrieben. Merkmale, Vorteile oder alternative Ausführungsbeispiele können den jeweils anderen Kategorien zugeordnet werden, und umgekehrt. In anderen Worten, die Ansprüche für medizinische Bildgebungssysteme können durch Merkmale verbessert werden, die im Rahmen der Gradientenspulenanordnung beschrieben sind und/oder beansprucht werden, und umgekehrt.

Es ist zu verstehen, dass die offenbarten Techniken, die im Zusammenhang mit MRT-Systemen beschrieben werden, in Spulenanordnungen verschiedener weiterer bildgebender Verfahren eingesetzt werden können, in welchen Magnetfelder durch mehrere Spulen einer Spulenanordnung erzeugt werden.

Eine Spulenanordnung, insbesondere eine Gradientenspulenanordnung, wird im Folgenden beschrieben, welche in einem medizinischen bildgebenden System, beispielsweise einem Magnetresonanztomographie- (MRT-)System, angeordnet sein kann.

Die Gradientenspulenanordnung definiert in unterschiedlichen Raumrichtungen eine erste Achse und zumindest eine zweite Achse. Für jede der unterschiedlichen Raumrichtungen weist die Gradientenspulenanordnung jeweils zumindest eine Spule, in anderen Worten Gradientenspule, auf, welche konfiguriert ist, ein magnetisches Feld, insbesondere ein magnetisches Gradientenfeld, in der jeweiligen Raumrichtung, d.h. entlang der jeweiligen Achse in der Raumrichtung, zu erzeugen. Zum Beispiel kann eine erste (Gradienten-)Spule ein magnetisches (Gradienten)-Feld entlang der ersten Achse (d.h. in der ersten Raumrichtung) erzeugen. Entsprechendes gilt für die zweite (Gradienten-)Spule, und optional weitere Gradientenspulen in weiteren Raumrichtungen.

In verschiedenen hier beschriebenen Beispielen umfasst die erste Achse eine Z-Achse einer MRT-Anlage, entlang welcher eine Untersuchungsperson in der MRT-Anlage ausgerichtet ist. In verschiedenen Beispielen kann die zumindest eine zweite Achse die X-Achse oder Y-Achse des MRT-Systems umfassen. Es wäre jedoch auch denkbar, das die erste Achse eine von der X- oder Y-Achse des MRT-Systems umfasst, und entsprechend der beschriebenen Techniken in Relation zu einer oder beiden anderen Spulen optimiert wird.

Die mindestens eine zweite Achse kann eine zweite und eine dritte Achse umfassen, so dass die Gradientenspulenanordnung in unterschiedlichen Raumrichtungen eine erste, eine zweite und eine dritte Achse aufweist. In verschiedenen hier beschriebenen Beispielen kann die erste Achse die Z-Achse des MRT-Systems umfassen, die zweite Achse die Y-Achse, und die dritte Achse die X-Achse umfassen.

Die zumindest eine Gradientenspule für jede Raumrichtung, d.h. jeder Achse, ist derart ausgebildet, dass ihr magnetisches Gradientenfeld jeweils einen Maximalfeldbereich aufweist, welcher einer räumlichen Region entspricht, in der die Feldstärke des magnetischen Gradientenfelds mindestens einen vorbestimmten Prozentsatz der maximalen Feldstärke des magnetischen Gradientenfelds der Spule erreicht. In diesem Bereich erreicht der Betrag des erzeugten Feldes (d.h. bestehend aus allen drei Raumkomponenten) ein Maximum. In anderen Worten, ein Maximalfeldbereich kann ein Feldmaximum, d.h. ein Feldbetragsmaximum, umfassen, welches der maximalen magnetischen Feldstärke des magnetischen Gradientenfeldes entspricht.

In einigen Beispielen können sich die Feldstärken auf einen Bereich im Inneren der Spulen beziehen, in dem das jeweilige magnetische Gradientenfeld erzeugt wird. Die Feldstärken können sich auf den Bereich innerhalb der Z-Spule beziehen, in dem eine Untersuchungsperson angeordnet sein kann. Die Feldstärken können sich auf spezifische Punkte beziehen, in welchen sich jeweils alle drei Raumkomponenten (die durch die Spulen der unterschiedlichen Raumrichtungen, z.B. X-, Y, und Z-Richtung erzeugt werden) zu einer auf einen Patienten wirkenden resultierenden Feldstärke summieren können. In anderen Worten, es kann eine Überlagerung oder Superposition der Feldkomponenten vorliegen, deren maximale Feldstärke durch die beschriebenen Techniken reduziert werden kann.

Die Feldstärken, der Maximalfeldbereich, insbesondere das Feldmaximum, einer Spule können sich auf das gesamte Feld beziehen, das von der jeweiligen Spule erzeugt wird. Die Feldstärken, die Maximalfeldbereiche, sowie die Feldmaxima können sich auf einen (Teil-)Bereich beziehen, zum Bespiel auf einen Bereich der außerhalb des Iso-Zentrums liegt, und/oder der das Iso-Zentrum und/oder Field-of-View für ein MRT-System einschließt, zum Beispiel einen Bereich, in welchem eine Untersuchungsperson innerhalb der Gradientenspulenanordnung angeordnet sein kann.

Das Design der Gradientenspule in der ersten Raumrichtung, beispielsweise der Z-Gradientenspule, kann in Bezug auf die Gradientenspule der zumindest einen zweiten Achse optimiert werden. In einigen Beispiele kann das Design der Z-Gradientenspule in Bezug auf die X- und/oder Y-Achse optimiert werden.

Die Gradientenspule der ersten Achse ist derart konfiguriert, dass eine räumliche Überschneidung, in anderen Worten eine Überlappung oder räumlicher Überschneidungsbereich, ihres Maximalfeldbereichs mit dem Maximalfeldbereich des magnetischen Gradientenfelds in Richtung der zumindest einen zweiten Achse kleiner als ein Grenzwert ist. Dieses Kriterium kann auch umfassen, dass sich die Maximalfeldbereiche der Spulen in einigen Beispielen nicht überschneiden oder überlappen.

In bevorzugten Beispielen kann das Design der Gradientenspule in der ersten Raumrichtung, beispielsweise der Z-Gradientenspule, in Bezug auf die Gradientenspulen der zweiten (Y-Achse) und dritten (X-Achse) Achse optimiert werden.

Die Gradientenspule der ersten Achse kann derart konfiguriert sein, dass eine räumliche Überschneidung ihres Maximalfeldbereichs mit einem kombinierten Maximalfeldbereich der Gradientenspulen der zweiten und dritten Achse, der sich aus einer Kombination (Superposition/Überlagerung) der magnetischen Gradientenfelder in Richtung der zweiten und dritten Achse ergibt, kleiner als ein Grenzwert ist.

Es ist zu verstehen, dass die beschriebenen Techniken nicht auf eine Optimierung der Z-Gradientenspule limitiert sind, sondern auch für das Design einer beliebigen andere Gradientenspule verwendet werden können. Es ist beispielsweise auch denkbar, dass eine beliebige der Gradientenspulen der X-, Y, und Z-Achse, in Bezug auf eine beliebige andere der Gradientenspulen der X-, Y, und Z-Achse, oder in Bezug auf eine Kombination dieser Gradientenspulen, entsprechend den beschriebenen Techniken optimiert wird.

In anderen Worten, die Konfiguration der Gradientenspule der ersten Achse ist so gestaltet, dass ihr Maximalfeldbereich entweder nur minimal, d.h. unterhalb eines Grenzwertes, oder gar nicht mit dem Maximalfeldbereich des magnetischen Gradientenfelds in Richtung der zumindest einen zweiten Achse interagiert. Die Konfiguration der Gradientenspule der ersten Achse sorgt dafür, dass die Maximalfeldbereiche der ersten und er zumindest einen zweiten Achse sich entweder nur minimal oder gar nicht überlagern, d.h. dass eine Superposition ihrer Maximalfeldbereiche minimiert wird oder sogar völlig ausgeschlossen ist.

Somit wird anstelle der Optimierung einzelner Achsen der Gradientenspule die Gesamtstimulationswirkung der Spulen mehrerer oder aller Raumrichtungen berücksichtigt. Durch die Verschiebung der Position der Feld(betrags-)maxima der einzelnen Gradientenfelder wird die stimulierende Wirkung auf den Körper des Patienten verringert. Dies ermöglicht eine sicherere Anwendung von MR-Scannern, besonders in Bezug auf das Risiko von PNS (periphere Nervenstimulation) und Kardiostimulation. Dadurch kann die Leistung des Gradientensystems gesteigert werden, ohne die Stimulationsschwellen zu überschreiten. Im Vergleich zu bisherigen Lösungen, bei denen eine Erhöhung der Induktivität der Spule oder eine Verschlechterung der Linearität in Kauf genommen wurde, ermöglichen die beschriebenen Techniken eine Verbesserung der Stimulationsperformance, ohne diese Parameter negativ zu beeinflussen.

Die Gradientenspulenanordnung kann so konfiguriert sein, dass der vorbestimmte Prozentsatz 90%, welcher den Maximalfeldbereich definieren kann, umfasst. Alternativ kann der vorbestimmte Prozentsatz auch 80%, oder 70% umfassen.

Dies ermöglicht eine flexible Anpassung der Gradientenspulenanordnung an die spezifischen Anforderungen des MRT-Systems und der zu untersuchenden Patienten. Der vorbestimmte Prozentsatz kann in einzelnen Beispielen auch 60%, oder 50%, oder 40%, oder gar 30%, umfassen.

Der Grenzwert, der die Größe der Überschneidung definieren kann, kann einen absoluten Wert umfassen, der unter Verwenden der Maximalfeldbereiche der Gradientenspulen festgelegt werden kann. Beispielsweise kann der Grenzwert einem Prozentualanteil (Prozentsatz) eines der Maximalfeldbereiche oder des kombinierten Maximalfeldbereichs entsprechen. In anderen Worten, der Grenzwert kann als maximaler Wert der des räumlichen Überschneidungsbereichs angegeben werden, der die Größe der räumlichen Überschneidung limitiert. Der Grenzwert kann beispielsweise so gewählt sein, dass der räumliche Überschneidungsbereich kleiner ist als 5% des Maximalfeldbereichs des magnetischen Gradientenfelds in Richtung der ersten Achse, oder des Maximalfeldbereichs des magnetischen Gradientenfelds in Richtung der zweiten oder der dritten Achse, oder des kombinierten Maximalfeldbereichs der Gradientenfelder entlang der zweiten und dritten Achse. Alternativ kann der Grenzwert auch so gewählt sein, dass der Prozentualanteil statt 5% beispielsweise 10%, oder 20%, oder 30%, oder 40%, oder 50%, oder 60% umfassen kann.

Durch die Begrenzung der räumlichen Überschneidung der Maximalfeldbereiche kann eine unerwünschte Superposition der Feldmaxima, und dadurch Stimulation des Patienten durch die Gradientenfelder vermieden werden. Insbesondere kann der Grenzwert somit festlegen, wie weit sich die Maximalfeldbereiche, in anderen Worten Feldmaxima, der einzelnen Gradientenfelder überlappen oder überschneiden dürfen, und dabei Raumbereiche bilden, in denen durch Überlagerung, d.h. Summierung des Betrags der Feldstärken, besonders hohe summierte maximale Feldstärken auf eine Untersuchungsperson wirken können.

Die Gradientenspule der ersten Achse kann als Ganzkörperspule, und als Z-Gradientenspule, ausgeführt sein. Dies ermöglicht eine gleichmäßige und effiziente Erzeugung des magnetischen Gradientenfelds über den gesamten Körper des Patienten.

Die Gradientenspule der ersten Achse kann derart konfiguriert sein, dass das Maximum seiner Feldwirkung gegenüber dem Maximum der kombinierten Feldwirkungen der X- und Y-Achse verschoben ist. Dies kann beispielsweise erreicht werden, indem die Position des Feldmaximums, oder der Maximalfeldbereich, der magnetischen Feldstärke des Gradientenfelds der ersten Gradientenspule entlang der ersten Achse (beispielsweise der Z-Achse) verschoben wird, wie im Folgenden näher beschrieben wird.

Das Feldmaximum und/oder der Maximalfeldbereich der Gradientenspule der ersten Achse kann in einem räumlichen Abstand (entlang der ersten Achse) zu dem Feldmaximum und/oder Maximalfeldbereich der Gradientenspulen der zweiten und/oder dritten Achse angeordnet sein.

Durch die Verschiebung der Anordnung des Maximalfeldbereichs der Gradientenspule der ersten Achse relativ zu den Maximalfeldbereiche der zweiten und/oder der dritten Achse, oder des kombinierten Maximalfeldbereichs der zweiten und dritten Achse, kann eine bessere Kontrolle über die räumliche Anordnung der Maxima der magnetischen Gradientenfelder erreicht werden. Durch räumliche Verschiebung der Maximalfeldbereiche relativ zueinander kann die Summe aller Feldstärken der durch die Gradientenspulen erzeugten magnetischen Gradientenfelder, die auf eine Untersuchungsperson wirken, insbesondere die superpositionierten Magnetfelder in einem räumlichen Überschneidungsbereich, unter einem vorbestimmten Grenzwert liegen. Die räumliche Verschiebung kann zu einer sichereren und patientenfreundlicheren MRT-Untersuchung führen, indem sie die Einwirkung starker Magnetfelder auf den Körper minimiert, ohne die Spulenqualität zu beeinträchtigen.

Dies kann durch verschiedene optimierte Anordnungen in dem Design der Feldleiter der ersten Spule erreicht werden, insbesondere kann durch eine Optimierung der Feldleiterverteilung entlang der Spulen-Längsachse das Feldmaximum entlang der Längsachse der Spule verschoben werden.

In verschiedenen Beispielen kann die Gradientenspule der ersten Achse derart konfiguriert sein, dass sie im Bereich des durch die Gradientenspule der zumindest einen zweiten Achse erzeugten Maximalfeldbereichs entlang der ersten Achse eine reduzierte Feldleiterdichte oder Primärleiterdichte, insbesondere keinen Feldleiter oder Primärleiter, aufweist.

In einigen Beispielen kann eine Projektion des Maximalfeldbereichs der zumindest einen zweiten Achse, bzw. der zweiten und/oder dritten Achse, oder des kombinierten Maximalfeldbereichs der zweiten und dritten Achse, auf die erste Achse, einen Achsenabschnitt der ersten Achse definieren.

In dem Achsenabschnitt kann im Relation zu einem Vergleichsbereich, beispielsweise einem angrenzenden Vergleichsachsenabschnitt gleicher Breite entlang der ersten Spulenachse, das Design der Feldleiter/Primärleiter modifiziert sein, um die Position des Feldmaximums entlang der Spulenachse zu verschieben.

Beispielsweise können in diesem Achsenabschnitt weniger Windungen vorhanden sein, so dass eine reduzierte Feldleiterdichte vorhanden ist, welche maximal 5%, oder 10%, oder 20%, oder 30%, oder 40% im Vergleich zu dem Vergleichsachsenabschnitt betragen kann.

In einem radialen Bereich, der diesem Achsenabschnitt entspricht, d.h. radial außerhalb dieses Achsenabschnitts, kann kein Feldleiter, kein Primärleiter, der ersten Spule angeordnet sein.

Dies ermöglicht eine gezielte Reduzierung des Betrags der Feldstärke des resultierenden magnetischen Gradientenfelds im Bereich der Feldmaxima der zweiten und/oder dritten Achse, und somit eine Reduzierung der Stimulation des Patienten. Es ist zu verstehen, dass andere auch Designmodifikationen, die zu einer Verschiebung des Feldmaximums entlang der Spulenachse führen, möglich sein können.

Die Gradientenspule der ersten Achse kann derart konfiguriert sein, dass die Primärleiter in einem Bereich entlang der ersten Achse außerhalb des Achsenabschnitts des Maximalfeldbereichs der Gradientenspulen der zumindest einen zweiten Achse, der zweiten Achse oder der dritten, oder des kombinierten Maximalfeldbereichs der zweiten und dritten Achse, insbesondere in einem oder beiden unmittelbar angrenzenden Bereichen entlang der ersten Achse, mehrlagig ausgeführt sind. In anderen Worten, in einem oder beiden Bereichen (Spulenachsenabschnitten), die in axialer Richtung (der ersten Spule) direkt an den freien/reduzierten Bereich angrenzt bzw. angrenzen, können die Primärleiter in radialer Richtung mehrlagig ausgeführt sein. Die Primärleiter können beispielsweise zweilagig oder dreilagig ausgeführt sein. Dies ermöglicht eine effiziente Erzeugung des magnetischen Gradientenfelds und eine Reduzierung der Stimulation des Patienten. Die Primärleiter können das magnetische Gradientenfeld der Spule erzeugen.

Die Gradientenspule der ersten Achse kann derart konfiguriert sein, dass Sekundärleiter in dem Bereich reduzierter Feldleiterdichte bzw. ohne Feldleiter angeordnet sind, d.h. in einem Bereich entlang der ersten Achse innerhalb einem radialen Bereichs entsprechend des Achsenabschnittes des Maximalfeldbereichs der Gradientenspulen der zumindest einen zweiten Achse, der zweiten Achse oder der dritten, oder des kombinierten Maximalfeldbereichs der zweiten und dritten Achse. Dies ermöglicht eine gezielte Schirmung der Feldstärke des magnetischen Gradientenfeldes. Die Sekundärleiter können nicht zur Erzeugung des magnetischen Gradientenfeldes beitragen. Die Sekundärleiter können eine Abschirmung des magnetischen Gradientenfelds der zweiten Gradientenspule zum Spulenäußeren hin bewirken.

Das Gradientenfeld der Gradientenspule der ersten Achse kann rotationssymmetrisch bezüglich ihrer Längsachse, insbesondere einer Z-Achse des MRT-Systems, sein. Dies kann insbesondere in einem Linearitätsbereich oder in einem vorbestimmten Bereich um das Iso-Zentrum oder Zentrum der Spule zutreffen.

Dies ermöglicht eine gleichmäßige und effiziente Erzeugung des magnetischen Gradientenfelds.

Die Gradientenspule der ersten Achse kann spiegelsymmetrisch bezüglich einer Ebene durch das Iso-Zentrum der Gradientenspulenanordnung sein. Dies ermöglicht eine gleichmäßige und effiziente Erzeugung des magnetischen Gradientenfelds.

Entsprechend wird ein System zur medizinischen Bildgebung, insbesondere ein MRT-Gerät oder MRT-System, bereitgestellt, umfassend eine Gradientenspulenanordnung entsprechend der vorliegenden Offenbarung.

Obwohl die in der obigen Zusammenfassung und der folgenden detaillierten Beschreibung beschriebenen Merkmale im Zusammenhang mit spezifischen Beispielen beschrieben werden, ist zu verstehen, dass die Merkmale nicht nur in den jeweiligen Kombinationen verwendet werden können, sondern auch isoliert oder in beliebigen Kombinationen verwendet werden können, und Merkmale aus verschiedenen Beispielen der medizinischen Bildgebungssysteme und Spulenanordnungen miteinander kombiniert werden können und somit miteinander korrelieren, sofern nicht ausdrücklich anders angegeben.

Die obige Zusammenfassung soll daher nur einen kurzen Überblick über einige Merkmale einiger Ausführungsbeispiele und Implementierungen geben und ist nicht als Einschränkung zu verstehen. Andere Ausführungsformen können weitere als die oben beschriebenen Merkmale umfassen.

### Kurze Beschreibung der Zeichnungen

Die Erfindung wird nachfolgend anhand bevorzugter Ausführungsbeispiele mit Bezug auf die beiliegenden Zeichnungen näher erläutert.

Dabei bezeichnen in den Figuren gleiche Bezugszeichen gleiche oder ähnliche Elemente. Die Figuren sind schematische Darstellungen verschiedener Ausführungsbeispiele der Erfindung, wobei die in den Figuren dargestellten Elemente nicht notwendigerweise maßstabsgetreu dargestellt sind. Vielmehr sind die verschiedenen in den Figuren dargestellten Elemente derart wiedergegeben, dass ihre Funktion und genereller Zweck für den Fachmann verständlich wird.
Figur 1 zeigt schematisch eine Magnetresonanzanlage, gemäß einigen Ausführungsbeispielen.
Figur 2 zeigt schematisch eine herkömmliche Gradientenspule.
Figur 3 zeigt schematisch die Feldverteilung der herkömmlichen Gradientenspule der Figur 2.
Figur 4 zeigt schematisch die Magnetfeldstärkenverteilung der überlagerten Feldstärken aller Gradientenspulen einer herkömmlichen Gradientenspulenanordnung unter Verwendung der Gradientenspule der Figur 2.
Figur 5 zeigt schematisch eine optimierte Gradientenspule, gemäß einigen Ausführungsbeispielen.
Figur 6 zeigt schematisch einen Vergleich der Feldmaxima der Gradientenspulen der Figuren 2 und 5, gemäß einigen Ausführungsbeispielen.
Figur 7 zeigt schematisch die Magnetfeldstärkeverteilung der überlagerten Gradientenfelder der Gradientenspulenanordnung der Figur 3 unter Verwendung der optimierten Gradientenspule der Figur 5, gemäß einigen Ausführungsbeispielen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, welche im Zusammenhang mit den Figuren näher erläutert werden.

Dabei ist zu beachten, dass die Beschreibung der Ausführungsbeispiele nicht in einem beschränkenden Sinne zu verstehen ist. Der Umfang der Erfindung soll nicht durch die im Folgenden beschriebenen Ausführungsbeispiele oder durch die Figuren eingeschränkt werden, welche nur zur Veranschaulichung dienen.

Nachfolgend werden verschiedene Techniken für Gradientenspulenanordnungen, insbesondere zum Reduzieren der maximalen Feldwirkung auf Untersuchungspersonen, welche in Folge von Überlagerung der einzelnen Gradientenfelder auftreten können, detaillierter beschrieben.

Beim Betrieb von Magnetresonanztomographie (MRT)-Scannern sind die Patienten oder Probanden zeitlich veränderlichen magnetischen Feldern (Gradientenfeldern) ausgesetzt. Diese Gradientenfelder werden durch die Gradientenspulen des MRT-Scanners erzeugt und dienen dazu, die Ortskodierung der Messung vorzunehmen. Durch diese zeitlich veränderlichen Felder werden im Körper des Patienten elektrische Felder induziert, wodurch es zu einer Stimulation der Nerven ("periphere Nervenstimulation", PNS) kommen kann. Bei stärkeren Gradientenfeldern können nicht nur die Nerven, sondern auch der Herzmuskel (Kardiostimulation) stimuliert werden. Sowohl PNS als auch Kardiostimulation sind in der Regel unerwünscht und im Falle der Kardiostimulation sogar potenziell gefährlich.

Daher müssen die Amplituden und/oder Anstiegszeiten der Gradientenfelder entsprechend begrenzt werden, um PNS und Kardiostimulation zu vermeiden. Dies limitiert die erreichbare Bildgebungsperformance des Gradientensystems. Die Stimulationsschwelle, d.h. die Amplituden und Anstiegszeiten ab denen Stimulation auftreten kann, hängen vom Design der Gradientenspule ab, welche das Gradientenfeld erzeugt. Gradientenspulen mit einer höheren Ortskodierungsgenauigkeit (Feldlinearität) haben typischerweise niedrigere Stimulationsschwellen als Gradientenspulen mit schlechterer Linearität. Je höher die potenziell erzeugbare Gradientenstärke einer Spule ist, desto mehr muss diese möglicherweise aufgrund von PNS oder Kardiostimulation begrenzt werden.

Die Performance herkömmlicher Gradientenspulen wird durch einen entsprechend parametrisierten Stimulationsmonitor begrenzt. Dieser gewährleistet, dass nur ein geringer Anteil der Patienten beim Betrieb tatsächlich PNS erfährt. Die Grenzen des Monitors sind so gewählt, dass Kardiostimulation in jedem Fall ausgeschlossen ist.

Um die Stimulationsschwellen zu erhöhen, können dedizierte Systeme (z.B. Kopfgradientenspulen) verwendet werden, bei denen der Patient nicht an der Stelle des maximalen Feldeintrags liegt bzw. bei denen die Leiterbahnen so gelegt werden, dass wenig Stimulation auftritt.

Bisherige Vorschläge zur Optimierung der Stimulationsperformance von Gradientenspulen betrachten meist nur die Stimulationswirkung der einzelnen Achsen. Um die Schwellen zu erhöhen, wird dabei eine Erhöhung der Induktivität der Spule oder eine Verschlechterung der Linearität in Kauf genommen. Zudem sind stimulationsoptimierte Designs, die die Nervenstimulation explizit im Designprozess minimieren, für Ganzkörperspulen nur begrenzt einsetzbar oder führen zu starken Einbußen in der Gradientenperformance.

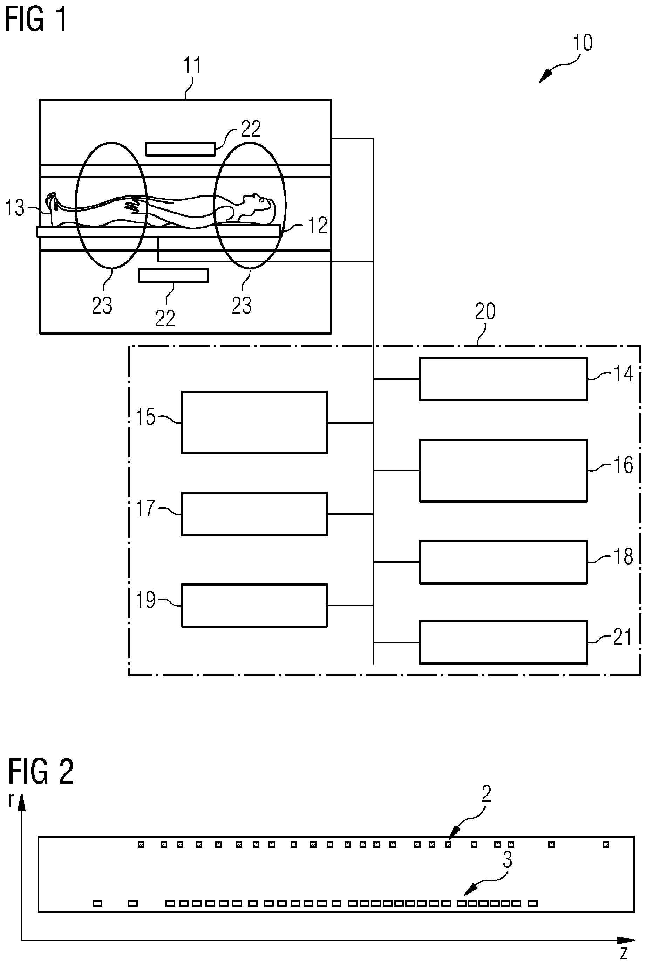

Figur 1 zeigt schematisch eine Magnetresonanzanlage 10, gemäß Ausführungsbeispielen der Erfindung.

Wie in Fig. 1 dargestellt, wird eine Magnetresonanzanlage 10 dargestellt, mit der, wie nachfolgend erläutert wird, ein Patient überwacht werden kann. Die Magnetresonanzanlage 10 weist einen Magneten 11 zur Erzeugung eines Polarisationsfelds B0 auf, wobei eine auf einer Liege 12 angeordnete Untersuchungsperson 13 in den Magneten 11 gefahren wird, um dort ortskodierte Magnetresonanzsignale bzw. MR-Daten aus der Untersuchungsperson bzw. dem Patienten 13 aufzunehmen. Die zur Signalaufnahme verwendete Gradientenspulen, insbesondere Gradientenspulen in X- und Y-Richtung 22, und in Z-Richtung (Ganzkörperspule) 23 oder Lokalspulen sind schematisch dargestellt. Durch Einstrahlen von Hochfrequenzpulsen und Schalten von Magnetfeldgradienten kann die durch das Polarisationsfeld B0 erzeugte Magnetisierung aus der Gleichgewichtslage ausgelenkt und ortskodiert werden, und die sich ergebende Magnetisierung wird von den Empfangsspulen detektiert. Wie durch Einstrahlen der HF-Pulse und durch Schalten von Magnetfeldgradienten in verschiedenen Kombinationen und Reihenfolgen MR-Bilder erzeugt werden können, ist dem Fachmann grundsätzlich bekannt und wird hier nicht näher erläutert.

Die Magnetresonanzanlage 10 weist weiterhin eine Steuereinheit 20 auf, die zur Steuerung der Magnetresonanzanlage 10 verwendet werden kann. Die Steuerung 20 weist eine Gradientensteuereinheit 15 zur Steuerung und Schaltung der notwendigen Magnetfeldgradienten auf. Eine HF-Steuereinheit 14 ist für die Steuerung und Generierung der HF-Pulse zur Auslenkung der Magnetisierung vorgesehen. Ei-ne Bildsequenzsteuerung 16 steuert die Abfolge der Magnetfeldgradienten und HF-Pulse und damit indirekt die Gradientensteuereinheit 15 und die HF-Steuereinheit 14. Über eine Eingabeeinheit 17 kann eine Bedienperson die Magnetresonanzanlage 10 steuern, und auf einer Anzeigeeinheit 18 können MR-Bilder und sonstige zur Steuerung notwendigen Informationen angezeigt werden. Eine Recheneinheit 19 mit mindestens einer Prozessoreinheit (nicht gezeigt) ist vorgesehen zur Steuerung der verschiedenen Einheiten in der Steuereinheit 20 und zur Durchführung von Rechenoperationen. Weiterhin ist eine Kamera 21 vorgesehen, mit welcher Bilder des Patienten 13 erfasst werden können. Die Rechen-einheit 19 ist ausgebildet, um aus den erfassten MR-Signalen die MR-Bilder zu berechnen und um anhand der erfassten Bilder eine Bewegung des Patienten 13 und ein Aus-maß der Bewegung zu bestimmen. Anhand eines Symbols (z.B. eines Kopfsymbols) wird das Ausmaß der Bewegung dann auf der Anzeige 18 dargestellt.

Bei MRT-Messungen werden in der Regel keine Pulse auf einzelnen Gradientenachsen, sondern auf Kombinationen verschiedener Achsen ausgespielt. Dabei ergibt sich die Stimulationswirkung aus der Überlagerung der Beiträge der Einzelachsen. Oft führt erst diese Überlagerung zur Stimulation, während die Einzelachsen einzeln nicht stimulieren.

Ziel ist es daher nicht, die Einzelachsen zu optimieren, sondern die gesamte Stimulationswirkung der Gradientenspule zu reduzieren. Diese ergibt sich aus der Summe aller Feldkomponenten der drei Achsen, d.h. der Feldkomponenten der magnetischen Gradientenfelder der X-, Y-, und Z-Achse.

Als Maß der Stimulationswirkung wird gemäß IEC 60601-2-33 der maximale Wert der Summe der Feldbeiträge auf einer Zylinderoberfläche im Anlagenkern (Radius 20 cm) betrachtet. Dabei wird an jeder axialen Position das Maximum der Summe der X-, Y- und Z-Komponenten aller 3 Achsen berechnet und als Funktion der axialen Position aufgetragen. Da dieses Maximum an unterschiedlichen axialen Positionen auf unterschiedlichen Umfangspositionen liegen kann, ergeben sich Kurvenverläufe wie im Beispiel gezeigt.

Das Maximum dieser Kurve ist ein Maß für die Stimulationswirkung der Gesamtspule. Liegen die Maxima der Einzelachsen-Beiträge nahe beieinander, wird das Maximum erhöht. Verschiebt man die Maxima axial, wird die Summenwirkung kleiner.

Ziel ist es, die Feldwirkung der Einzelachsen an unterschiedlichen Z-Positionen zu generieren, so dass die "Feldwirkung" der Gesamtspulenanordnung begrenzt ist. Da bei gegebenen Spulenanforderungen die Transversalspulen (X- und Y-Gradientenspulen) ähnlich sind, ist eine solche Verschiebung für sie im Vergleich zur Modifikation der Z-Gradientenspule schwieriger möglich. Daher wird hier das Design der Z-Gradientenspule so gewählt, dass ihr Maximum gegenüber den Maxima in X- und Y-Richtung in Richtung der Längsachse der Z-Gradientenspule verschoben ist.

Figur 2 zeigt schematisch einen Querschnitt entlang der Längsachse einer herkömmlichen Gradientenspule.

Die Gradientenspule 1 hat eine konventionelle Konfiguration mit Primärleitern 3 und Sekundärleitern 2 in einer koaxialen Anordnung um eine Längsachse, die parallel zur Z-Achse, oder mit der Z-Achse eines MRT-Systems zusammenfallen kann. Die Gradientenspule 1 kann beispielsweise eine Gradientenspule in Z-Richtung eines MRT-Systems umfassen.

Die Primärleiter 3 und Sekundärleiter 2 sind entlang der Längsachse der Gradientenspule 1, die der Z-Achse eines MRT-Systems, entsprechen kann, angeordnet.

Die Position des Feldmaximums, oder Feldwirkungsmaximums, der Gradientenspule wird durch die Anzahl der Leiter, welche die Sensitivität bestimmen, den Leiterquerschnitt abhängig vom Stromfluss, sowie die Spulendicke beeinflusst.

Die radiale Position der Leiter ist auf der Y-Diagrammachse dargestellt. Die radial innen dargestellten Leiter umfassen Primärleiter 3, die radial äußeren Leiter umfassen Sekundärleiter 2. Die komplette Gradientenspule 1 ergibt sich durch Spiegeln bei Z = 0, d.h. der Mitte der Spule, und Rotation um r = 0.

Die Position und Form des Feldstärkeverlaufs wird durch die Anordnung der Primär- und Sekundärleiter bestimmt. Durch geschickte Wahl dieser Anordnung kann die Feldwirkung der Z-Achse gegenüber den Transversalachsen verschoben werden, um die Stimulationswirkung der Gesamtspule zu reduzieren.

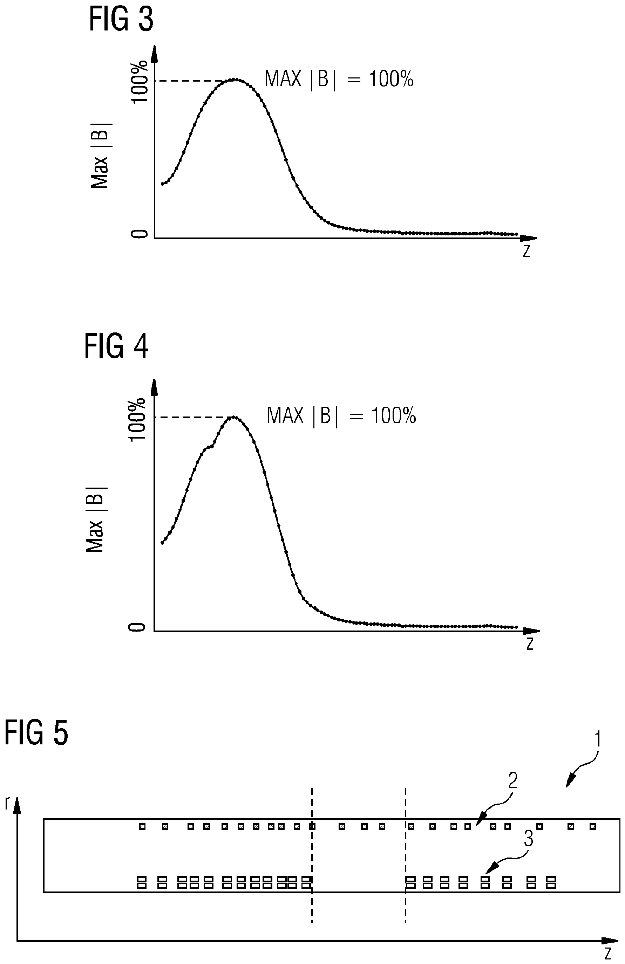

Die maximale Feldwirkung dieses Z-Achsendesigns auf dem r = 20 cm Zylinder ist in der folgenden Abbildung Figur 3 dargestellt.

Figur 3 zeigt schematisch die Feldverteilung der herkömmlichen Gradientenspule der Figur 2.

Wie in Figur 3 zu sehen, sind auf der Y-Diagrammachse die Feldbetragsmaxima des Gradientenfelds aufgetragen, und die Messpositionen entlang der Z-Achse auf der X-Diagrammachse. Das Feldmaximum ist auf 100% normiert, und entlang der Z-Achse fallen die magnetischen Feldstärken beiderseits ab. Das Maximum der Feldwirkung tritt im Schwerpunkt der Leiter auf.

Figur 4 zeigt schematisch die resultierende Magnetfeldstärke der überlagerten Gradientenfelder aller Gradientenspulen einer Gradientenspulenanordnung unter Verwendung der Gradientenspule der Figur 2.

Als Summe der Beiträge der magnetischen Feldstärken aller drei Achsen ergibt sich die in Figur 4 gezeigte Kurve entlang der Z-Achse, welche an der räumlichen Position der Kurve in Figur 3 ebenfalls ein Feldmaximum aufweist, dieses ist im Diagramm ebenfalls auf 100% normiert. Die Feldstärke fällt beiderseits ab, wobei auf der Seite, die zum Zentrum der Spule gerichtet ist, ein Nebenmaximum zu sehen ist, das durch die Beiträge der Spulen in X- und Y-Richtung bewirkt wird.

Figur 5 zeigt schematisch eine optimierte Gradientenspule 1, gemäß einigen Ausführungsbeispielen.

Die allgemeine Anordnung der Komponenten entspricht der Figur 2, jedoch weisen die Primärleiter ein unterschiedliches Design entlang der Spulenlängsachse (Z-Achse) auf. Die Konfiguration der Gradientenspule entlang der Z-Achse kann ergibt sich aus einer Optimierung basierend auf den Feldmaxima der X- und Y-Gradientenspulen.

Um die maximale Feldwirkung der Gradientenspule 1 zu verkleinern, ohne die Gradientenstärke oder andere Spuleneigenschaften stark zu beeinflussen, werden in einem Abschnitt entlang der Z-Achse im Bereich der Z-Position des ursprünglichen Maximums, welches den Maximalfeldbereichen der X- und Y-Gradientenspulen entspricht, keine Feldleiter, d.h. keine Primärleiter 3, der Z-Gradientenspule positioniert.

Insbesondere kann der Abschnitt entlang der Z-Achse, in dem keine Feldleiter angeordnet sind, der Position und Breite eines des Achsenabschnitts entlang der Z-Achse des Maximalfeldbereichs einer oder beider der anderen Spulen in X- und/oder Y-Richtung, oder des kombinierten Maximalfeldbereichs der X- und Y-Achse entsprechen. Um trotzdem die nötige Sensitivität der Spule zu erreichen, werden die übrigen Leiter verdoppelt, d.h. zweilagig in radialer Richtung angeordnet.

Dadurch verdoppelt sich die Sensitivität an diesen Positionen und die Feldeigenschaften werden ähnlich dem ursprünglichen Design erreicht. Durch diese gezielte Positionierung der Leiter bei gleichzeitiger Kompensation der Sensitivität kann die Feldwirkung der Z-Achse und damit die Stimulationswirkung der Gesamtspule reduziert werden, ohne die Gradientenperformance einzuschränken.

Die Anordnung der Sekundärleiter 2 entspricht der von Figur 2, so dass zur Abschirmung der Spule nach außen Sekundärleiter 2 in dem freien Bereich angeordnet sein können.

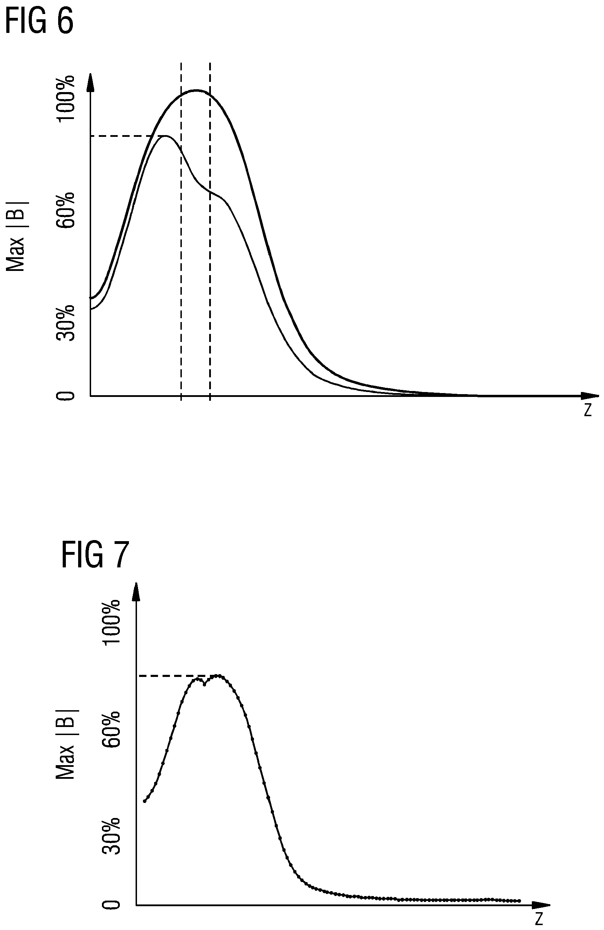

Figur 6 zeigt schematisch einen Vergleich der Feldmaxima der Gradientenspulen der Figuren 2 und 5, gemäß einigen Ausführungsbeispielen.

Zum Vergleich ist die herkömmliche Kurve der Figur 3 zusätzlich zu der reduzierten Feldstärkekurve der optimierten Gradientenspule der Figur 5 eingezeichnet.

Wie in Figur 6 zu sehen, ergibt sich im Vergleich zur herkömmlichen Kurve ein reduziertes Feldmaximum, d.h. eine reduzierte Feldwirkung der Z-Gradientenspule, da die Position des ursprünglichen Maximums in dem Bereich zwischen den gestrichelten Linien freigelassen (ohne Z-Feldleiter) ist. Insbesondere konnte durch die Lücke im Design der Primärleiter und das Verdoppeln der Primärleiterlagen außerhalb der Lücke das Maximum der Feldwirkung gesenkt und die Position des Maximums nach links, d.h. zur Spulenmitte hin, verschoben werden. Im Bereich der Z-Feldleiterlücke ergibt sich eine leichte abgeflachte Kurve.

Figur 7 zeigt schematisch die Magnetfeldstärkeverteilung der überlagerten Gradientenfelder der Gradientenspulenanordnung entsprechend der Figur 3 unter Verwendung der optimierten Gradientenspule der Figur 5, gemäß einigen Ausführungsbeispielen.

Wie in Figur 7 zu sehen, erhält man eine Feldwirkung auf eine Untersuchungsperson, die den überlagerten Feldstärken der Gesamtspule bestehend aus den Beiträgen der magnetischen Gradientenfelder in X-, Y-, und Z-Achse entspricht, mit einem reduzierten Maximum, im Vergleich zu der Feldstärkeverteilung der Figur 4.

Das maximale Feld auf dem r = 20 cm Zylinder konnte somit gesenkt werden, wobei diese Verringerung in gleichem Maß in die Stimulationswirkung der Gradientenspule eingeht.

Durch die gezielte Positionierung der Feldleiter bei gleichzeitiger Kompensation der Sensitivität kann die Feldwirkung der Z-Achse und damit die Stimulationswirkung der Gesamtspule reduziert werden, ohne die Gradientenperformance einzuschränken.

Durch die in der vorliegenden Offenbarung beschriebe Anordnung der Feldleiter wird nicht die Stimulationswirkung der einzelnen Gradientenachsen optimiert, d.h. die Maxima gesenkt, sondern die Zusammenwirkung der einzelnen Gradientenspulen in der Gesamtspulenanordnung. Dies wird erreicht, indem gezielt die Position des maximalen Feldes der Z-Achse entlang der Z-Achse, von den Maxima der X- und Y-Achse weg, verschoben wird.

Anstatt die Z-Leiter einschichtig wie üblich anzuordnen, werden sie, mit einer Lücke im Bereich der X/Y-Feldmaxima, zumindest teilweise im übrigen Bereich zweilagig geführt. Dadurch kann die Position des Feldmaximums beeinflusst werden, ohne die Gradientenperformance einzuschränken. Prinzipiell wäre auch eine dreilagige Anordnung der Z-Leiter möglich, um die Feldwirkung weiter zu optimieren.

Die Stimulationsoptimierung zielt somit nicht auf die einzelnen Achsen, sondern auf die Gesamtwirkung des Gradientensystems unter Beibehaltung der Gradientenstärke und Feldlinearität. Dies wird durch gezielte mehrlagige Leiteranordnung, insbesondere der Z-Achse, erreicht, welche die Position der Feldmaxima verschiebt, und die Stimulation reduziert.

Daher lassen sich aus dem oben Gesagten einige allgemeine Schlussfolgerungen ziehen:
Eine Gradientenspulenanordnung für ein MRT-System kann in drei orthogonalen Raumrichtungen eine X-Achse, eine Y-Achse und eine Z-Achse definieren. Die Gradientenspulenanordnung kann jeweilige Gradientenspulen für jede der X-, Y- und Z-Achsen aufweisen, welche so konfiguriert sind, dass sie ein magnetisches Gradientenfeld in Richtung ihrer jeweiligen Achse erzeugen. Das magnetische Gradientenfeld jeder Achse kann jeweils ein Feldmaximum, d.h. einen maximalen Feldwert des magnetischen Gradientenfelds, oder allgemeiner einen Maximalfeldbereich aufweisen, welcher einer räumlichen Region entspricht, in der die Feldstärke des magnetischen Gradientenfelds mindestens einen vorbestimmten Prozentsatz der maximalen Feldstärke des magnetischen Gradientenfelds erreicht. Die Gradientenspule der Z-Achse kann derart konfiguriert sein, dass ihr Maximalfeldbereich keine räumliche Überschneidung mit dem Maximalfeldbereich des magnetischen Gradientenfelds in X- und/oder Y-Richtung aufweist.

Die Z-Achse kann der ersten Achse in einer Raumrichtung entsprechen. Die Gradientenspule der Z-Achse kann der ersten Gradientenspule entsprechen. Die X- oder Y- Achse kann der zumindest einen zweiten Achse in einer weiteren Raumrichtung entsprechen. Insbesondere kann die Y-Achse der zweiten Achse, und die X-Achse der dritten Achse entsprechen.

Der vorbestimmte Prozentsatz kann einen speziellen Wert von 50%, oder 60%, oder 70%, oder 75%, oder 80%, oder 85%, oder 90%, oder 95%, oder 96%, oder 97%, oder 98%, oder 99% umfassen.

Das Feldmaximum und/oder der Maximalfeldbereich der Gradientenspule der Z-Achse kann mindestens in einen räumlichen Abstand entlang der Z-Achse zu dem Maximalfeldbereich der Gradientenspulen der X- und/oder Y-Achse angeordnet sein.

Der räumliche Abstand kann auch relativ zur Breite des Maximalfeldbereichs der X-Achse, oder des Maximalfeldbereichs Y-Achse, oder des Maximalfeldbereichs der Z-Achse, definiert sein. Zum Beispiel könnte die Breite entsprechend der vollen Breite des Maximums auf halber Maximalhöhe (FWHM) definiert sein, oder entsprechend auf 60%-Breite, oder 70%-Breite, oder 80%-Breite, oder 90%-Breite, d.h. der vollen Breite des Feldmaximums entlang der Achse, insbesondere der Z-Achse, bei Werten die dem Prozentsatz des maximalen Feldwerts entsprechen.

Beispielsweise könnte der Abstand 50%, oder 60%, oder 70%, oder 75%, oder 80% dieser Breite betragen. Beispielsweise könnte der Abstand auch absolut definiert sein, als > 10 cm, > 20 cm, > 30 cm, oder > 40 cm.

In anderen Worten kann der Abstand zwischen dem Feldmaximum (d.h. Maximum der Feldstärkeverteilung) der Z-Gradientenspule (d.h. Gradientenspule des magnetischen Gradientenfeldes in Z-Richtung, Gradientenspule der Z-Achse) und dem Feldmaximum einer oder beider der X- und/oder Y-Gradientenspule, beziehungsweise allgemeiner zwischen den Maximalfeldbereichen, d.h. zwischen beliebigen Punkten der Maximalfeldbereiche, entlang der Z-Achse größer sein als die 90ö-Breite (oder 80%-Breite, oder 70%-Breite, oder 60%-Breite, oder 50%-Breite) des Maximalfeldbereichs der X-Gradientenspule (Gradientenspule des magnetischen Gradientenfeldes in X-Richtung, Gradientenspule der X-Achse) oder der Y-Gradientenspule (Gradientenspule des magnetischen Gradientenfeldes in Y-Richtung, Gradientenspule der Y-Achse), wobei der Abstand bzw. die Breite in Z-Richtung gemessen oder definiert ist.

Der räumliche Abstand kann in absoluten Maßen definiert sein, wie z.B. 5 Zentimeter, 10 Zentimeter oder sogar 20 Zentimeter, abhängig von der spezifischen Konfiguration und den Anforderungen des Systems.

Der Abstand könnte auch in Bezug auf die gesamte Spulenlänge definiert sein, z.B. als 10% oder 20% der Gesamtlänge der Spule in der Z-Achse.

Durch die räumliche Verschiebung der Maximalfeldbereiche relativ zueinander kann die Summe aller Feldstärken der durch die Gradientenspulen erzeugen magnetischen Gradientenfelder unter einem vorbestimmten Grenzwert liegen.

Die Gradientenspule der Z-Achse kann derart konfiguriert sein, dass sie im Bereich des durch die Gradientenspulen in X- und/oder Y-Richtung erzeugten Maximalfeldbereichs entlang der Z-Achse keinen Feldleiter, insbesondere keinen Primärleiter, aufweist. Es ist jedoch auch denkbar, dass die X- und/oder Y-Gradientenspule in Bezug auf die Z-Gradientenspule optimiert wird bzw. werden.

Die Gradientenspule der Z-Achse (und entsprechend auch die Gradientenspule der X-Achse oder Y-Achse) können derart konfiguriert sein, dass in bestimmten Bereichen entlang ihrer jeweiligen Achsen kein Feldleiter angeordnet ist. Dieses Fehlen eines Feldleiters in einem bestimmten Bereich entlang der Achse führt zu einer Verschiebung des Schwerpunkts der Leiter.

Diese Verschiebung des Schwerpunkts beeinflusst die räumliche Verteilung des magnetischen Gradientenfelds. Indem kein Feldleiter in einem bestimmten Bereich platziert wird, wird der magnetische Fluss in diesem Bereich reduziert. Dies kann dazu verwendet werden, den Maximalfeldbereich der Gradientenspule zu steuern und gezielt zu platzieren, wobei der Bereich ohne Feldleiter im Wesentlichen eine Zone mit reduzierter magnetischer Feldstärke darstellt.

Die Verschiebung des Schwerpunkts der Leiter entlang der Achse kann die Wechselwirkung zwischen den Gradientenspulen der verschiedenen Achsen beeinflussen. Zum Beispiel kann das Fehlen eines Feldleiters in der Gradientenspule der Z-Achse dazu führen, dass ihr Maximalfeldbereich keine oder geringere räumliche Überschneidung mit dem Maximalfeldbereich des magnetischen Gradientenfelds in X- und/oder Y-Richtung aufweist.

Darüber hinaus kann diese Konfiguration dazu verwendet werden, die Gesamtfeldstärke der durch die Gradientenspulen erzeugten magnetischen Gradientenfelder unter einem vorbestimmten Grenzwert zu halten. Dies kann besonders wichtig sein, um sicherzustellen, dass das System innerhalb sicherer Grenzen für medizinische Anwendungen wie der Magnetresonanztomographie (MRT) arbeitet.

Die Gradientenspule der Z-Achse kann derart konfiguriert sein, dass Primärleiter in einem Bereich entlang der Z-Achse außerhalb des Maximalfeldbereichs der Gradientenspulen der X- und/oder Y-Achse mehrlagig, insbesondere zweilagig, ausgeführt sind.

Bereiche ohne Feldleiter können ein Teil der Gradientenspulenanordnung entlang einer bestimmten Achse (z.B. Z- oder X-Achse) sein, in welchen kein Leiterelement, das zur Erzeugung oder Steuerung des magnetischen Gradientenfelds beiträgt, platziert ist.

Der Bereich ohne Feldleiter kann entlang der jeweiligen Achse angeordnet sein, um die räumliche Verteilung des magnetischen Gradientenfelds zu beeinflussen.

Indem der Bereich ohne Feldleiter bestimmte Regionen der Gradientenspule ausschließt, beeinflusst er die Form und Stärke des erzeugten magnetischen Gradientenfelds. Er kann beispielsweise dazu verwendet werden, Überschneidungen des Maximalfeldbereichs der Gradientenspulen in den verschiedenen Raumrichtungen zu vermeiden.

Der Bereich ohne Feldleiter kann durch ein besonderes Design der Gradientenspulenanordnung erreicht werden, bei dem in einem bestimmten Abschnitt der Spule bewusst keine Leitermaterialien verwendet werden. Dies kann zweilagige oder mehrlagige Ausführungen in anderen Bereichen der Spule mit einschließen, um die gewünschten magnetischen Eigenschaften in diesen Bereichen zu erreichen. Die zweilagigen oder mehrlagigen Bereiche können unmittelbar angrenzen an den Bereich ohne Feldleiter.

Der Bereich ohne Feldleiter kann zum Beispiel dazu beitragen, die Gesamtfeldstärke der durch die Gradientenspulen erzeugten magnetischen Gradientenfelder unter einem vorbestimmten Grenzwert zu halten, um die Sicherheitsstandards für medizinische Anwendungen einzuhalten.

Die Gradientenspule der Z-Achse kann derart konfiguriert sein, dass Sekundärleiter in einem Bereich entlang der Z-Achse innerhalb des Maximalfeldbereichs der Gradientenspulen der X- und/oder Y-Achse angeordnet sind.

Das Gradientenfeld der Gradientenspule der Z-Achse kann rotationssymmetrisch bezüglich ihrer Längsachse, insbesondere der Z-Achse, sein.

Die Gradientenspule der Z-Achse kann spiegelsymmetrisch bezüglich einer Ebene durch das Iso-Zentrum der Gradientenspulenanordnung sein.

Die Gradientenspule in Z-Richtung kann als Ganzkörperspule ausgeführt sein.

Die Gradientenspule der X-Achse kann derart konfiguriert sein, dass ihr Maximalfeldbereich keine räumliche Überschneidung mit dem Maximalfeldbereich des magnetischen Gradientenfelds in Y-Richtung aufweist.

Die Gradientenspule der X-Achse kann derart konfiguriert sein, dass sie im Bereich des durch die Gradientenspulen in Y-Richtung erzeugten Maximalfeldbereichs entlang der X-Achse keinen Feldleiter aufweist.

Primärleiter sind die Hauptleiterelemente in einer Gradientenspulenanordnung, die für die Erzeugung des magnetischen Gradientenfelds verantwortlich sind. Sie tragen den Hauptstrom und sind somit direkt an der Erzeugung des Gradientenfelds beteiligt. Die Primärleiter können in verschiedenen Schichten oder Lagen angeordnet sein, um bestimmte magnetische Eigenschaften zu erreichen, wie beispielsweise die Kontrolle des magnetischen Flusses in bestimmten Raumrichtungen.

Es kann ein spezifischer Bereich entlang einer Achse definiert sein, in dem keine Primärleiter angeordnet sind. Dies ermöglicht eine gezielte Anordnung des Maximums entlang der Längsachse magnetischen Gradientenfelds. Die Primärleiter in einem Bereich entlang der Z-Achse außerhalb des Maximalfeldbereichs der Gradientenspulen der X- und/oder Y-Achse können mehrlagig, insbesondere zweilagig, ausgeführt sein.

Sekundärleiter in der Gradientenspulenanordnung haben die Aufgabe, das von den Primärleitern erzeugte Magnetfeld abzuschirmen. Sie tragen nicht direkt zur Erzeugung des Magnetfelds bei, sondern beeinflussen dessen Form oder Ausrichtung in einer Richtung nach außerhalb der Spule.

In einem Magnetresonanztomographie (MRT)-System wird die Z-Achse gewöhnlich als die Achse definiert, die parallel zum Hauptmagnetfeld (B0-Feld) des MRT-Geräts verläuft. In der klinischen Praxis ist das Hauptmagnetfeld normalerweise horizontal ausgerichtet und die Patienten werden entlang dieser Achse in die Maschine geschoben. Daher wird die Z-Achse oft auch als "longitudinale" oder "vertikale" Achse bezeichnet.

Die X- und Y-Achsen sind dann senkrecht zur Z-Achse ausgerichtet und liegen in einer Ebene senkrecht zum Hauptmagnetfeld. Sie bilden zusammen mit der Z-Achse ein kartesisches Koordinatensystem, das zur Beschreibung der räumlichen Position und Orientierung der Gradientenspulen und zur Planung und Interpretation der MRT-Scans verwendet wird.

Die Gradientenspulenanordnung kann so konzipiert sein, dass sie in den drei orthogonalen Raumrichtungen X, Y und Z ausgerichtet ist. Für jede dieser Raumrichtungen sind spezifische Gradientenspulen vorhanden. Diese Spulen sind so ausgelegt, dass sie ein magnetisches Gradientenfeld entlang ihrer jeweiligen Raumrichtung erzeugen.

Das Magnetresonanztomographie- (MRT-) System verfügt somit über eine Gradientenspulenanordnung, welche spezifische Gradientenspulen für jede Achse beinhaltet. Diese Anordnung umfasst Gradientenspulen, die für die X-Richtung konfiguriert sind und dazu ausgelegt sind, ein magnetisches Gradientenfeld speziell entlang dieser X-Achse zu erzeugen.

Ähnlich sind die Gradientenspulen für die Y-Richtung gestaltet. Sie sind so konfiguriert, dass sie ein magnetisches Gradientenfeld entlang der Y-Achse erzeugen, um genaue bildgebende Ergebnisse in dieser spezifischen Richtung zu liefern.

Ebenso beinhaltet die Gradientenspulenanordnung Gradientenspulen, die für die Z-Richtung konfiguriert sind. Diese Spulen sind so konzipiert, dass sie ein magnetisches Gradientenfeld in Z-Richtung erzeugen.

Die Gradientenspulenanordnung umfasst eine oder mehrere Gradientenspulen, die als "X-Gradientenspule(n)" bezeichnet werden kann. Diese X-Gradientenspule ist speziell konfiguriert, um ein magnetisches Gradientenfeld entlang der X-Achse, d.h. in X-Richtung, zu erzeugen. Weiter umfasst die Gradientenspulenanordnung eine oder mehrere Gradientenspulen, die als "Y-Gradientenspule(n)" bezeichnet werden kann, welche speziell dafür ausgelegt ist, ein magnetisches Gradientenfeld entlang der Y-Achse, d.h. in Y-Richtung, zu erzeugen. Weiter enthält die Gradientenspulenanordnung eine oder mehrere Gradientenspulen, die als "Z-Gradientenspule(n)" bezeichnet werden kann, welche speziell dafür ausgelegt ist, ein magnetisches Gradientenfeld entlang der Z-Achse, d.h. in Z-Richtung, zu erzeugen.

Die Gradientenspule, die entlang der Z-Achse ausgerichtet ist, ermöglicht es, dass ihr Feldmaximum in der Z-Richtung gegenüber mindestens einem der Feldmaxima, die von den Gradientenspulen in X- und Y-Richtung erzeugt werden, räumlich verschoben ist.

Die sogenannten "Feldmaxima" können definiert sein als die räumlichen Regionen, in anderen Worten Feldmaximumsbereiche oder Maximalfeldbereiche, innerhalb des magnetischen Felds, in denen die magnetische Feldstärke die auf eine Untersuchungsperson in der MRT-Anlage wirkt, ihren höchsten Wert erreicht. Diese Maxima sind nicht nur einzelne Punkte, sondern räumliche Bereiche, die sich in den X-, Y- und Z-Richtungen erstrecken. Jedes Feldmaximum wird dabei durch eine umgebende Zone charakterisiert, in der das magnetische Feld auf ein Niveau von 90%, oder 80%, oder 70%, oder 60%, oder 50%, oder 40%, oder 30%, oder 20%, oder 10% des maximalen Werts abfällt.

Ein "Feldleiter", spezifischer ein "Primärleiter", ist ein Element innerhalb der Gradientenspule, das in der Lage ist, elektrischen Strom zu führen. Dieses Leiterelement erzeugt dadurch ein magnetisches Gradientenfeld. Die Gradientenspulen, die jeweils die X-, Y- oder Z-Achse definieren, können einen oder mehrere dieser Feldleiter aufweisen. Der spezifische Fokus liegt auf der Konfiguration und Positionierung dieser Feldleiter innerhalb der Gradientenspule, die die Z-Achse definiert, um ein optimiertes magnetisches Gradientenfeld zu erzeugen.

Es ist hier anzumerken, dass "Primärleiter" sich explizit auf die Leiterelemente beziehen, die direkt zur Erzeugung des magnetischen Gradientenfeldes beitragen. Sie sind zu unterscheiden von "Sekundärleitern", die in der Regel dazu dienen, die Felder abzuschirmen und häufig radial weiter außen positioniert sind.

Im Kontext dieser Patentanmeldung bezieht sich die "radiale Richtung" auf die Richtung, die senkrecht zur Achse der Spule steht, sich also von der Mitte der Spule aus radial nach außen erstreckt. Die "axiale Richtung" hingegen bezieht sich auf die Richtung, die parallel zur Achse der Spule verläuft, also entlang der Längsachse der Spule von einem Ende zum anderen.

In der vorgeschlagenen Konfiguration des MRT-Systems können die Primärleiter, die zur Erzeugung des magnetischen Gradientenfelds dienen, in einer mehrschichtigen Anordnung strukturiert sein, insbesondere in einer zweilagigen Anordnung. Dies bedeutet, dass es mehrere Schichten von Primärleitern innerhalb der Gradientenspule gibt, wobei "zweilagig" sich auf eine spezifische Ausführung bezieht, bei der genau zwei Schichten von Primärleitern übereinander angeordnet sind.

Die mehrschichtige Anordnung der Primärleiter kann in verschiedenen Formen auftreten. Beispielsweise können die Leiter in aufeinanderfolgenden Schichten entlang der radialen Richtung angeordnet sein, wobei die radiale Richtung als die Richtung bezeichnet wird, die orthogonal zur axialen Richtung und zum Umfang des MRT-Systems verläuft. Diese Art von mehrschichtiger Anordnung kann dazu beitragen, das Magnetfeldprofil zu verbessern und die Summe aller Feldstärken innerhalb der Feldmaxima zu optimieren.

Die Gradientenspule, die die Z-Achse im vorgeschlagenen MRT-System definiert, kann zwei spezifische Arten von Symmetrie aufweisen: axiale Rotationssymmetrie und Spiegelsymmetrie.

Die axiale Symmetrie bezieht sich auf eine Gleichmäßigkeit der Struktur und des erzeugten magnetischen Felds um die Z-Achse oder Längsachse, welche auch als die Mittelachse der Gradientenspule bezeichnet werden kann. Dies bedeutet, dass bei einer Drehung um diese Achse, die Form und die Eigenschaften der Gradientenspule gleich bleiben. Insbesondere kann diese Symmetrie bedeuten, dass die Positionen und/oder Konfigurationen der Primärleiter innerhalb der Gradientenspule so angeordnet sind, dass sie ein magnetisches Feld erzeugen, das gleichmäßig um die Z-Achse verteilt ist.

Die Spiegelsymmetrie kann sich auf eine Symmetrie der Spule und des erzeugten magnetischen Feldes in Bezug auf eine Ebene beziehen, die senkrecht zur Z-Achse verläuft und durch das Iso-Zentrum des MRT-Systems geht. Das Iso-Zentrum ist typischerweise der Mittelpunkt des Volumens, das von der Gradientenspule umschlossen wird, und wird als der Punkt definiert, an dem die Feldstärken der X-, Y- und Z-Gradientenspulen ihren maximalen Wert erreichen. Bei dieser Art von Symmetrie bleiben die Form und die Eigenschaften der Gradientenspule gleich, wenn man sie über diese Ebene spiegelt.

Beide Arten von Symmetrie können sowohl auf die physische Struktur der Spule als auch auf das durch sie erzeugte magnetische Feld anwendbar sein und können dazu beitragen, das Magnetfeldprofil zu optimieren und gleichzeitig die Komplexität der Spulenanordnung zu minimieren.

Die Position des Feldmaximums der Gradientenspule, die die Z-Achse im vorgeschlagenen MRT-System definiert, kann in der Z-Achse im Vergleich zu den Positionen der Feldmaxima der Gradientenspulen, die die X- und Y-Achsen definieren, verschoben sein. Diese spezielle Verschiebung bezeichnet eine räumliche Diskrepanz, wobei das Feldmaximum der Z-Achse nicht mit den Feldmaxima der X- und Y-Achsen übereinstimmt, sondern in der Z-Achse versetzt ist.

Eine derartige Verschiebung kann nicht nur durch eine vollständige Lücke der Feldleiter einer Spule erreicht werden, sondern auch durch andere Designoptimierungen. Beispielsweise könnten weitere Bereiche außerhalb der X-/Y-Maxima dreilagig oder mehrlagig ausgeführt sein, während der Bereich selbst eine reduzierte Anzahl von Feldleitern aufweist.

Der Maximalfeldbereich kann das Feldmaximum umfassen. Anstelle des Maximalfeldbereiches kann eine Verschiebung auch einzig mit dem Feldmaximum der jeweiligen Spulen definiert werden. Die Feldmaxima können gegeneinander verschoben sein, wobei die einen vordefinierten Abstand zueinander einnehmen. Beispielsweise kann dieser absolut oder relativ wie oben für die Maximalfeldbereiche mithilfe der Breiten der Maximalfeldbereiche definiert sein.

Die genaue Verschiebung kann durch die spezifische Gestaltung und Anordnung der Primärleiter innerhalb der Z-Gradientenspule erreicht werden. Insbesondere kann die Konfiguration der Primärleiter so gestaltet sein, dass sie ein Magnetfeld erzeugt, dessen Maximum an einem anderen Punkt entlang der Z-Achse liegt als die Magnetfelder, die durch die Gradientenspulen der X- und Y-Achsen erzeugt werden. Das könnte beispielsweise durch eine Variation in der Dichte oder Anordnung der Primärleiter entlang der Achse der Gradientenspule erreicht werden. Insbesondere kann innerhalb der Gradientenspule, die die Z-Achse definiert, in einem bestimmten Bereich kein Primärleiter angeordnet sein. Dieser spezifische Bereich kann sich an der Stelle befinden, an der das Feldmaximum des magnetischen Gradientenfeldes, das von dieser Spule erzeugt wird, auftritt. Durch das Fehlen von Primärleitern in diesem Bereich kann es möglich sein, ein gezielt geformtes und optimiertes magnetisches Feld zu erzeugen. Es kann auch zur Minimierung von unerwünschten Magnetfeldkomponenten beitragen, die sonst durch die Anwesenheit von Primärleitern in diesem Bereich entstehen könnten.

Die genaue Größe und Position dieses Bereichs ohne Primärleiter innerhalb der Gradientenspule kann variieren, je nach den spezifischen Anforderungen des MRT-Systems, den Eigenschaften der anderen Gradientenspulen und den Zielen der Magnetfeldoptimierung. Es könnte jedoch typischerweise eine Region sein, die eine Breite aufweist, die der Breite entspricht, in der die magnetische Feldstärke (mindestens) einer weiteren Gradientenspule in einer anderen Raumrichtung mindestens einen vorbestimmten Prozentsatz ihres maximalen Werts erreicht, beispielsweise 90%, 80%, 70%, 60%, 50 oder ein anderer vorbestimmter Prozentsatz.

Obwohl die Erfindung in Bezug auf bestimmte bevorzugte Ausführungsbeispiele gezeigt und beschrieben wurde, werden durch Fachleute nach dem Lesen und Verstehen der Beschreibung Äquivalente und Änderungen vorgenommen werden. Die vorliegende Erfindung umfasst alle derartigen Äquivalente und Änderungen und ist nur durch den Umfang der beiliegenden Ansprüche begrenzt. Unabhängig vom grammatikalischen Geschlecht eines bestimmten Begriffes sind Personen mit männlicher, weiblicher oder anderer Geschlechteridentität mit umfasst.

## Patentansprüche

1. Gradientenspulenanordnung für ein Magnetresonanztomographie- (MRT-)System,
wobei die Gradientenspulenanordnung in unterschiedlichen Raumrichtungen eine erste Achse und zumindest eine zweite Achse definiert,
wobei die Gradientenspulenanordnung für jede der unterschiedlichen Raumrichtungen jeweils zumindest eine Gradientenspule aufweist, welche konfiguriert ist, ein magnetisches Gradientenfeld in Richtung der jeweiligen Achse zu erzeugen,
wobei die Gradientenspule für jede Raumrichtung derart ausgebildet ist, dass ihr magnetisches Gradientenfeld jeweils einen Maximalfeldbereich aufweist, welcher einer räumlichen Region entspricht, in der die Feldstärke des magnetischen Gradientenfelds mindestens einen vorbestimmten Prozentsatz der maximalen Feldstärke des magnetischen Gradientenfelds erreicht,
wobei die Gradientenspule der ersten Achse derart konfiguriert ist, dass eine räumliche Überschneidung ihres Maximalfeldbereichs mit dem Maximalfeldbereich des magnetischen Gradientenfelds in Richtung der zumindest einen zweiten Achse kleiner als ein Grenzwert ist.

2. Gradientenspulenanordnung nach Anspruch 1, wobei der vorbestimmte Prozentsatz 90% umfasst.

3. Gradientenspulenanordnung nach einem der vorhergehenden Ansprüche, wobei der Grenzwert derart gewählt ist, dass die räumliche Überschneidung kleiner als 10% des Maximalfeldbereichs des magnetischen Gradientenfelds in Richtung der ersten Achse oder zumindest einen zweiten Achse ist.

4. Gradientenspulenanordnung nach einem der vorhergehenden Ansprüche, wobei die Gradientenspule der ersten Achse als Ganzkörperspule ausgeführt ist.

5. Gradientenspulenanordnung nach einem der vorhergehenden Ansprüche, wobei der Maximalfeldbereich der Gradientenspule der ersten Achse in einen räumlichen Abstand ohne Überschneidung entlang der ersten Achse zu dem Maximalfeldbereich der Gradientenspulen zumindest einen zweiten Achse angeordnet ist.

6. Gradientenspulenanordnung nach einem der vorhergehenden Ansprüche, wobei durch räumliche Verschiebung der Maximalfeldbereiche relativ zueinander die Summe der Feldstärken der durch die Gradientenspulen erzeugten magnetischen Gradientenfelder, die auf eine Untersuchungsperson wirken, unter einem vorbestimmten Grenzwert liegt.

7. Gradientenspulenanordnung nach einem der vorhergehenden Ansprüche, wobei die Gradientenspule der ersten Achse derart konfiguriert ist, dass sie in einem Achsenabschnitt der ersten Achse, der dem Maximalfeldbereich der zumindest einen zweiten Achse entspricht, eine reduzierte Feldleiterdichte aufweist, welche maximal 10% der Feldleiterdichte eines angrenzenden Achsenabschnitts der Gradientenspule der ersten Achse gleicher Breite aufweist.

8. Gradientenspulenanordnung nach einem der vorhergehenden Ansprüche, wobei die Gradientenspule der ersten Achse derart konfiguriert ist, dass sie in einem Achsenabschnitt der ersten Achse, der dem Maximalfeldbereich der Gradientenspule der zumindest einen zweiten Achse entspricht, keine Feldleiter aufweist.

9. Gradientenspulenanordnung nach einem der vorhergehenden Ansprüche, wobei die Gradientenspule der ersten Achse derart konfiguriert ist, dass Primärleiter in einem Bereich außerhalb einem Achsenabschnitt entlang der ersten Achse, der dem Maximalfeldbereich der zumindest einen zweiten Achse entspricht, mehrlagig ausgeführt sind.

10. Gradientenspulenanordnung nach einem der vorhergehenden Ansprüche,
wobei die erste Achse die Z-Achse des MRT-Systems umfasst, welche einer Längsachse des MRT-Systems entspricht, entlang der eine Untersuchungsperson ausgerichtet sein kann,
wobei die zumindest eine zweite Achse die X-Achse oder die Y-Achse des MRT-Systems umfasst.

11. Gradientenspulenanordnung nach einem der vorhergehenden Ansprüche,
wobei die zumindest eine zweite Achse eine zweite Achse und eine dritte Achse umfasst, so dass die Gradientenspulenanordnung die erste Achse, eine zweite Achse, und eine dritte Achse definiert,
wobei die erste Achse die Z-Achse des MRT-Systems umfasst, welche einer Längsachse des MRT-Systems entspricht, entlang der eine Untersuchungsperson ausgerichtet sein kann,
wobei die zweite Achse die Y-Achse des MRT-Systems umfasst, und
wobei die dritte Achse die X-Achse des MRT-Systems umfasst.

12. Gradientenspulenanordnung nach Anspruch 11,
wobei die Gradientenspule der Z-Achse derart konfiguriert ist, dass eine räumliche Überschneidung ihres Maximalfeldbereichs mit einem kombinierten Maximalfeldbereich, der einer Kombination der magnetischen Gradientenfelder in Richtung der Y-Achse und X-Achse entspricht, kleiner als der Grenzwert ist.

13. Gradientenspulenanordnung nach einem der vorhergehenden Ansprüche, wobei das Gradientenfeld der Gradientenspule der ersten Achse rotationssymmetrisch bezüglich ihrer Längsachse, insbesondere einer Z-Achse des MRT-Systems, ist.

14. Gradientenspulenanordnung nach einem der vorhergehenden Ansprüche, wobei die Gradientenspule der ersten Achse spiegelsymmetrisch bezüglich einer Ebene durch das Iso-Zentrum der Gradientenspulenanordnung ist.

15. MRT-System umfassend eine Gradientenspulenanordnung nach einem der Ansprüche 1 bis 14.

## Geänderte Patentansprüche

### Geänderte Patentansprüche gemäss Regel 137(2) EPÜ.

1. Gradientenspulenanordnung für ein Magnetresonanztomographie- (MRT-)System,
wobei die Gradientenspulenanordnung in unterschiedlichen Raumrichtungen eine erste Achse und zumindest eine zweite Achse definiert,
wobei die Gradientenspulenanordnung für jede der unterschiedlichen Raumrichtungen jeweils zumindest eine Gradientenspule aufweist, welche konfiguriert ist, ein magnetisches Gradientenfeld in Richtung der jeweiligen Achse zu erzeugen,
wobei die Gradientenspule für jede Raumrichtung derart ausgebildet ist, dass ihr magnetisches Gradientenfeld jeweils einen Maximalfeldbereich aufweist, welcher einer räumlichen Region entspricht, in der die Feldstärke des magnetischen Gradientenfelds mindestens einen vorbestimmten Prozentsatz der maximalen Feldstärke des magnetischen Gradientenfelds und der Betrag aller drei Raumkomponenten des magnetischen Gradientenfelds ein Maximum erreicht,
wobei die Gradientenspule der ersten Achse derart konfiguriert ist, dass eine räumliche Überschneidung ihres Maximalfeldbereichs mit dem Maximalfeldbereich des magnetischen Gradientenfelds in Richtung der zumindest einen zweiten Achse kleiner als ein Grenzwert ist, wobei der Grenzwert derart gewählt ist, dass die räumliche Überschneidung kleiner als 60% des Maximalfeldbereichs des magnetischen Gradientenfelds in Richtung der ersten Achse oder zumindest einen zweiten Achse ist.

2. Gradientenspulenanordnung nach Anspruch 1, wobei der vorbestimmte Prozentsatz 90% umfasst.

3. Gradientenspulenanordnung nach einem der vorhergehenden Ansprüche, wobei der Grenzwert derart gewählt ist, dass die räumliche Überschneidung kleiner als 10% des Maximalfeldbereichs des magnetischen Gradientenfelds in Richtung der ersten Achse oder zumindest einen zweiten Achse ist.

4. Gradientenspulenanordnung nach einem der vorhergehenden Ansprüche, wobei die Gradientenspule der ersten Achse als Ganzkörperspule ausgeführt ist.

5. Gradientenspulenanordnung nach einem der vorhergehenden Ansprüche, wobei der Maximalfeldbereich der Gradientenspule der ersten Achse in einen räumlichen Abstand ohne Überschneidung entlang der ersten Achse zu dem Maximalfeldbereich der Gradientenspulen zumindest einen zweiten Achse angeordnet ist.

6. Gradientenspulenanordnung nach einem der vorhergehenden Ansprüche, wobei die Gradientenspule der ersten Achse derart konfiguriert ist, dass sie in einem Achsenabschnitt der ersten Achse, der dem Maximalfeldbereich der zumindest einen zweiten Achse entspricht, eine reduzierte Feldleiterdichte aufweist, welche maximal 10% der Feldleiterdichte eines angrenzenden Achsenabschnitts der Gradientenspule der ersten Achse gleicher Breite aufweist.

7. Gradientenspulenanordnung nach einem der vorhergehenden Ansprüche, wobei die Gradientenspule der ersten Achse derart konfiguriert ist, dass sie in einem Achsenabschnitt der ersten Achse, der dem Maximalfeldbereich der Gradientenspule der zumindest einen zweiten Achse entspricht, keine Feldleiter aufweist.

8. Gradientenspulenanordnung nach einem der vorhergehenden Ansprüche, wobei die Gradientenspule der ersten Achse derart konfiguriert ist, dass Primärleiter in einem Bereich außerhalb einem Achsenabschnitt entlang der ersten Achse, der dem Maximalfeldbereich der zumindest einen zweiten Achse entspricht, mehrlagig ausgeführt sind.

9. Gradientenspulenanordnung nach einem der vorhergehenden Ansprüche,
wobei die erste Achse die Z-Achse des MRT-Systems umfasst, welche einer Längsachse des MRT-Systems entspricht, entlang der eine Untersuchungsperson ausgerichtet sein kann,
wobei die zumindest eine zweite Achse die X-Achse oder die Y-Achse des MRT-Systems umfasst.

10. Gradientenspulenanordnung nach einem der vorhergehenden Ansprüche,
wobei die zumindest eine zweite Achse eine zweite Achse und eine dritte Achse umfasst, so dass die Gradientenspulenanordnung die erste Achse, eine zweite Achse, und eine dritte Achse definiert,
wobei die erste Achse die Z-Achse des MRT-Systems umfasst, welche einer Längsachse des MRT-Systems entspricht, entlang der eine Untersuchungsperson ausgerichtet sein kann,
wobei die zweite Achse die Y-Achse des MRT-Systems umfasst, und
wobei die dritte Achse die X-Achse des MRT-Systems umfasst.

11. Gradientenspulenanordnung nach Anspruch 10,
wobei die Gradientenspule der Z-Achse derart konfiguriert ist, dass eine räumliche Überschneidung ihres Maximalfeldbereichs mit einem kombinierten Maximalfeldbereich, der einer Kombination der magnetischen Gradientenfelder in Richtung der Y-Achse und X-Achse entspricht, kleiner als der Grenzwert ist.

12. Gradientenspulenanordnung nach einem der vorhergehenden Ansprüche, wobei das Gradientenfeld der Gradientenspule der ersten Achse rotationssymmetrisch bezüglich ihrer Längsachse, insbesondere einer Z-Achse des MRT-Systems, ist.

13. Gradientenspulenanordnung nach einem der vorhergehenden Ansprüche, wobei die Gradientenspule der ersten Achse spiegelsymmetrisch bezüglich einer Ebene durch das Iso-Zentrum der Gradientenspulenanordnung ist.

14. MRT-System umfassend eine Gradientenspulenanordnung nach einem der Ansprüche 1 bis 13.
